(19) Europäisches Patentamt / European Patent Office / Office européen des brevets

(11) **EP 4 489 295 A1**

(12) **EUROPEAN PATENT APPLICATION**
published in accordance with Art. 153(4) EPC

(43) Date of publication:
**08.01.2025 Bulletin 2025/02**

(21) Application number: **23770826.8**

(22) Date of filing: **15.03.2023**

(51) International Patent Classification (IPC):
***H02P 29/024*** *(2016.01)*

(52) Cooperative Patent Classification (CPC):
**H02P 29/024**

(86) International application number:
**PCT/JP2023/010040**

(87) International publication number:
**WO 2023/176873 (21.09.2023 Gazette 2023/38)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **15.03.2022 JP 2022040385**

(71) Applicant: **DAIKIN INDUSTRIES, LTD.**
**Osaka-shi, Osaka 530-0001 (JP)**

(72) Inventors:
• **OKAMOTO, Hideyuki**
  **Osaka-shi, Osaka 530-0001 (JP)**
• **DOI, Akihiro**
  **Osaka-shi, Osaka 530-0001 (JP)**
• **ARAKI, Takeshi**
  **Osaka-shi, Osaka 530-0001 (JP)**

(74) Representative: **Hoffmann Eitle**
**Patent- und Rechtsanwälte PartmbB**
**Arabellastraße 30**
**81925 München (DE)**

(54) **STATE DETERMINATION DEVICE, MOTOR DRIVE SYSTEM, FREEZING SYSTEM, FAN SYSTEM, AND STATE DETERMINATION METHOD**

(57) A controller (31) determines whether a state of a motor (50) or a device (70) is a specific state, based on a first frequency component (C 1) of a signal based on a current or voltage of the motor (50). When the signal is a DC signal, a frequency of the first frequency component (C1) is a frequency of a specific frequency component (Cs) that is less than one time a mechanical angular frequency (fm) of the motor (50). When the signal is an AC signal, the frequency of the first frequency component (C1) is a frequency obtained by subtracting the frequency of the specific frequency component (Cs) from a fundamental frequency (f0) of the signal or a frequency obtained by adding the frequency of the specific frequency component (Cs) to the fundamental frequency (f0) of the signal.

FIG.1

EP 4 489 295 A1

## Description

Technical Field

The present disclosure relates to a state determination device, a motor drive system, a refrigeration system, a fan system, and a state determination method.

Background Art

PTL 1 discloses a failure sign detection device for an air conditioner including a compressor including a motor and a drive device configured to output a three phase current to the motor. The failure sign detection device includes a conversion unit configured to calculate a q-axis current of the motor from a measured value of the three phase current and a rotation angle of a rotor of the motor, and an abnormality detection unit configured to detect an abnormality of the compressor by comparing an evaluation value calculated by performing frequency analysis on the q-axis current with a reference value.

Citation List

Patent Literature

PTL 1: Japanese Unexamined Patent Application Publication No. 2017-221023

Summary of Invention

Technical Problem

The state of a motor or a device on which the motor is mounted may be a specific state in which a variation appears in a frequency component related to a specific frequency component less than one time the mechanical angular frequency of the motor among frequency components of a signal based on the current or voltage of the motor. However, PTL 1 does not disclose the specific state, and neither discloses nor suggests determining whether the state of the motor or the device on which the motor is mounted is the specific state.

Solution to Problem

A first aspect of the present disclosure relates to a state determination device configured to determine a state of a motor (50) driven by a motor drive device (20) or a device (70) on which the motor (50) is mounted, and the state determination device includes: a controller (31) configured to determine whether the state of the motor (50) or the device (70) is a specific state, based on a first frequency component (C1) of a signal based on a current or voltage of the motor (50), in which when the signal is a DC signal, a frequency of the first frequency component (C1) is a frequency of a specific frequency component (Cs), when the signal is an AC signal, the frequency of the first frequency component (C1) is a frequency obtained by subtracting the frequency of the specific frequency component (Cs) from a fundamental frequency (f0) of the signal or a frequency obtained by adding the frequency of the specific frequency component (Cs) to the fundamental frequency (f0) of the signal, and the specific frequency component (Cs) is a frequency component less than one time a mechanical angular frequency (fm) of the motor (50).

In the first aspect, it is possible to determine whether the state of the motor (50) or the device (70) is the specific state.

A second aspect of the present disclosure is the state determination device according to the first aspect, in which the motor (50) is configured to rotationally drive a shaft (55) supported by a sliding bearing.

A third aspect of the present disclosure is the state determination device according to the first or second aspect, in which the DC signal indicates a square root of a sum of square values of phase currents (iu, iv, iw) of the motor (50).

A fourth aspect of the present disclosure is the state determination device according to any one of the first to third aspects, in which the frequency of the specific frequency component (Cs) is a frequency obtained by multiplying the mechanical angular frequency (fm) of the motor (50) by a specific ratio.

A fifth aspect of the present disclosure is the state determination device according to the fourth aspect, in which the specific ratio is a fractional ratio represented by a reciprocal of a natural number.

A sixth aspect of the present disclosure is the state determination device according to any one of the first to fifth aspects, in which the specific state is a state in which a shaft rotationally driven by the motor (50) or a bearing of the shaft is worn.

In the sixth aspect, it is possible to detect the state in which the shaft or the bearing is worn.

A seventh aspect of the present disclosure is the state determination device according to the fourth aspect, in which the specific state is a state in which a shaft rotationally driven by the motor (50) or a bearing of the shaft is worn, and the specific ratio is 1/3 or 2/3.

In the seventh aspect, it is possible to detect the state in which the shaft or the bearing is worn.

An eighth aspect of the present disclosure relates to a motor drive system, and the motor drive system includes: a motor drive device (20) configured to drive a motor (50) mounted on a device (70); and a state determination device (30) configured to determine a state of the motor (50) or the device (70), in which the state determination device (30) is the state determination device according to any one of the first to seventh aspects.

A ninth aspect of the present disclosure relates to a refrigeration system, and the refrigeration system includes: a refrigerant circuit (RR1) including a compressor (CC); a motor drive device (20) configured to drive a motor (50) mounted on the compressor (CC); and a state determination device (30) configured to determine a state of the motor (50) or the compressor (CC), in which the state determination device (30) is the state determination device according to any one of the first to seventh aspects.

A tenth aspect of the present disclosure relates to a fan system, and the fan system includes: a fan (FF); a motor drive device (20) configured to drive a motor (50) mounted on the fan (FF); and a state determination device (30) configured to determine a state of the motor (50) or the fan (FF), in which the state determination device (30) is the state determination device according to any one of the first to seventh aspects.

An eleventh aspect of the present disclosure relates to a state determination method for determining a state of a motor (50) driven by a motor drive device (20) or a device (70) on which the motor (50) is mounted, and the state determination method includes: acquiring a first frequency component (C1) of a signal based on a current or voltage of the motor (50); and determining whether the state of the motor (50) or the device (70) is a specific state, based on the first frequency component (C1), in which when the signal is a DC signal, a frequency of the first frequency component (C1) is a frequency of a specific frequency component (Cs), when the signal is an AC signal, the frequency of the first frequency component (C1) is a frequency obtained by subtracting the frequency of the specific frequency component (Cs) from a fundamental frequency (f0) of the signal or a frequency obtained by adding the frequency of the specific frequency component (Cs) to the fundamental frequency (f0) of the signal, and the specific frequency component (Cs) is a frequency component less than one time a mechanical angular frequency (fm) of the motor (50).

In the eleventh aspect, it is possible to determine whether the state of the motor (50) or the device (70) is the specific state.

Brief Description of Drawings

Fig. 1 is a circuit diagram illustrating a configuration of a motor drive system according to an embodiment.
Fig. 2 is a waveform diagram illustrating a DC signal and an AC signal.
Fig. 3 is a graph illustrating first frequency components included in the DC signal.
Fig. 4 is a graph illustrating first frequency components included in the AC signal.
Fig. 5 is a flowchart illustrating a first determination process.
Fig. 6 is a flowchart illustrating a second determination process.
Fig. 7 is a timing chart illustrating the second determination process.
Fig. 8 is a flowchart illustrating a third determination process.
Fig. 9 is a timing chart illustrating the third determination process.
Fig. 10 is a flowchart illustrating a fourth determination process.
Fig. 11 is a timing chart illustrating the fourth determination process.
Fig. 12 is a schematic diagram illustrating a configuration of a refrigeration system.
Fig. 13 is a schematic diagram illustrating a configuration of a fan system.
Fig. 14 is a vertical cross-sectional view illustrating a shaft and bearings.

Description of Embodiments

Hereinafter, embodiments will be described in detail with reference to the drawings. In the drawings, the same or corresponding parts are denoted by the same reference numerals, and the description thereof will not be repeated.

(Motor Drive System)

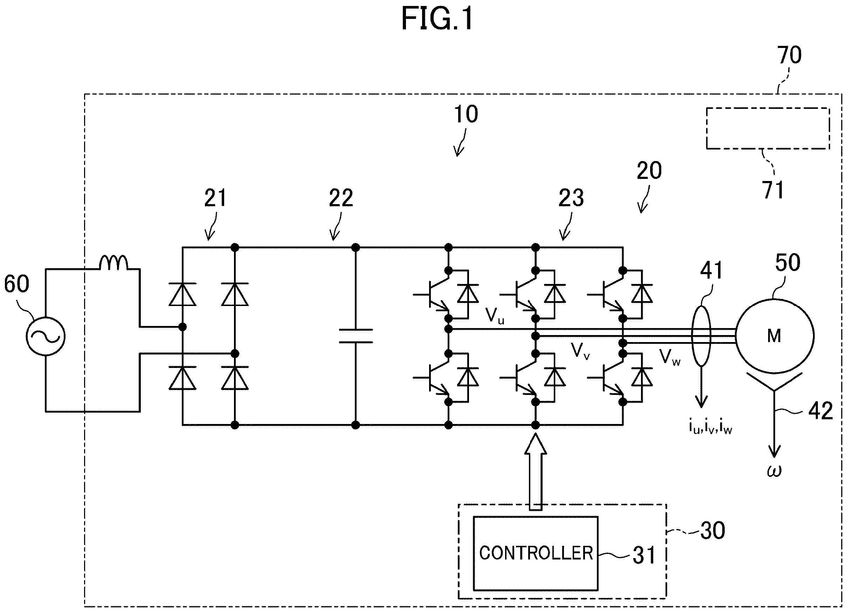

Fig. 1 illustrates a configuration of a motor drive system (10) according to an embodiment. The motor drive system (10) drives a three phase AC motor (50) using electric power supplied from an AC power source (60). The motor (50) is mounted on a device (70). For example, the motor (50) is an IPM motor (Interior Permanent Magnet Motor). The device (70) is provided with a control device (71) that controls the operation of the device (70). In this example, the motor drive system (10) includes a motor drive device (20) and a state determination device (30).

[Motor Drive Device]

The motor drive device (20) drives the motor (50). Specifically, the motor drive device (20) converts the electric power supplied from the AC power source (60) into output AC power (three phase AC power) having a predetermined frequency and voltage, and supplies the output AC power to the motor (50). In this example, the motor drive device (20) includes a converter (21), a DC unit (22), and an inverter (23).

The converter (21) rectifies the electric power supplied from the AC power source (60). In this example, the converter (21) performs full-wave rectification on the AC power supplied from the AC power source (60). For example, the converter (21) is constituted by a diode bridge circuit in which a plurality of rectifier diodes are connected in a bridge shape. The DC unit (22) smooths an output of the converter (21). In this example, the DC unit (22) includes a capacitor.

The inverter (23) includes a plurality of switching elements, and converts an output of the DC unit (22) into the output AC power (three phase AC power) having the predetermined frequency and voltage by a switching operation of the plurality of switching elements.

In this example, the inverter (23) includes six bridge-connected switching elements and six freewheeling diodes connected in anti-parallel to the six switching elements, respectively. Specifically, the inverter (23) includes three switching legs each of which includes two switching elements connected in series. Midpoints of the three switching legs (specifically, connection points between the switching elements on the upper arm side and the switching elements on the lower arm side) are connected to three windings (U-phase, V phase, and W-phase windings) of the motor (50), respectively.

[Various Sensors]

The motor drive device (20) is provided with various sensors such as a phase current detection unit (41) and an electrical angular frequency detection unit (42).

The phase current detection unit (41) detects three phase currents (a U-phase current (iu), a V-phase current (iv), and a W-phase current (iw)) respectively flowing through the three windings (not illustrated) of the motor (50). For example, the phase current detection unit (41) may detect all of the three phase currents (iu, iv, iw) or may detect two of the three phase currents (iu, iv, iw) and derive the remaining one phase current, based on the detected two phase currents. In addition, the phase current detection unit (41) may derive the three phase currents (iu, iv, iw) from a DC current detected by a shunt resistance (not illustrated) provided in the DC unit (22) and a switching pattern.

The electrical angular frequency detection unit (42) detects an electrical angular frequency ($\omega$) of the motor (50). Detection signals of the various sensors are transmitted to a controller (31). The electrical angular frequency detection unit (42) is not an essential component of the present invention, and the electrical angular frequency ($\omega$) of the motor (50) may be calculated by another method and estimated in a sensorless manner.

[State Determination Device]

The state determination device (30) determines the state of the motor (50) or the device (70). The state determination device (30) includes the controller (31). In this example, the state determination device (30) controls the motor (50) by controlling the motor drive device (20) in addition to the determination of the state of the motor (50) or the device (70).

[Controller]

The controller (31) performs a determination process. In the determination process, the controller (31) determines whether the state of the motor (50) or the device (70) is a specific state, based on a first frequency component (C1) of a signal based on a current or voltage of the motor (50). The determination process is an example of a state determination method.

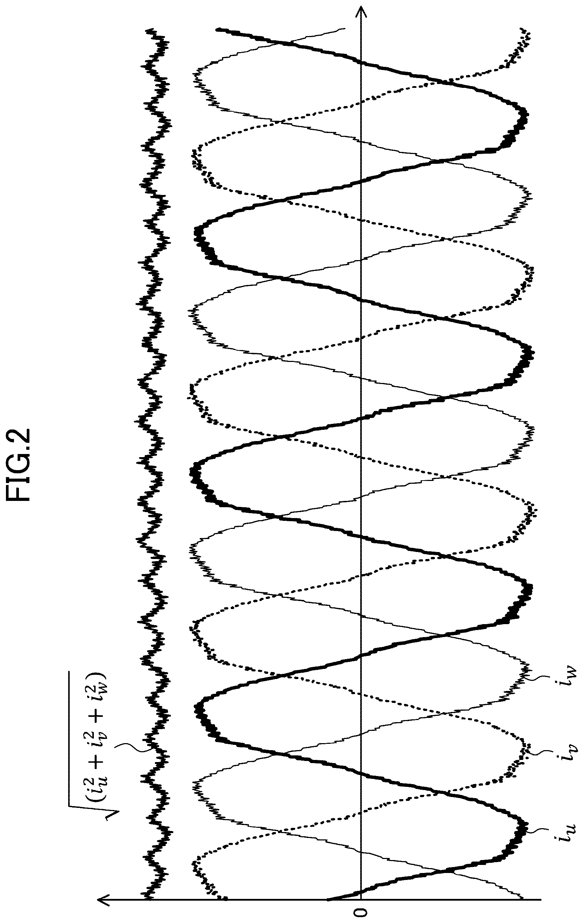

The signal may be a DC signal or an AC signal. Fig. 2 illustrates the DC signal and the AC signal. Fig. 2 illustrates the "square root of the sum of the squares of the phase currents (iu, iv, iw) of the motor (50)" as an example of the DC signal, and the "phase currents (iu, iv, iw) of the motor (50)" as an example of the AC signal.

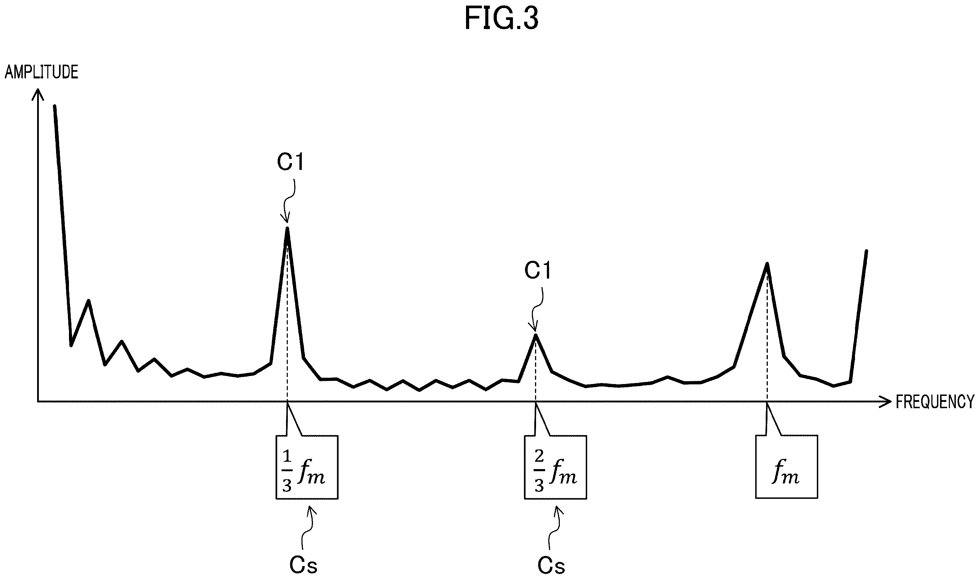

As illustrated in FIG. 3, when the signal is the DC signal, the frequency of the first frequency component (C1) is the frequency of a specific frequency component (Cs).

The specific frequency component (Cs) is a frequency component less than one time a mechanical angular frequency (fm) of the motor (50). The frequency of the specific frequency component (Cs) is a frequency obtained by multiplying the mechanical angular frequency (fm) of the motor (50) by a specific ratio. The specific ratio is a fractional ratio represented by the reciprocal of a natural number. For example, the specific ratio is 1/3 or 2/3.

In the example of Fig. 3, the frequency of the specific frequency component (Cs) is a frequency "1/3fm" obtained by multiplying the mechanical angular frequency (fm) of the motor (50) by "1/3" or a frequency "2/3fm" obtained by multiplying the mechanical angular frequency (fm) of the motor (50) by "2/3". The frequency of the first frequency component (C1) is "1/3fm" or "2/3fm".

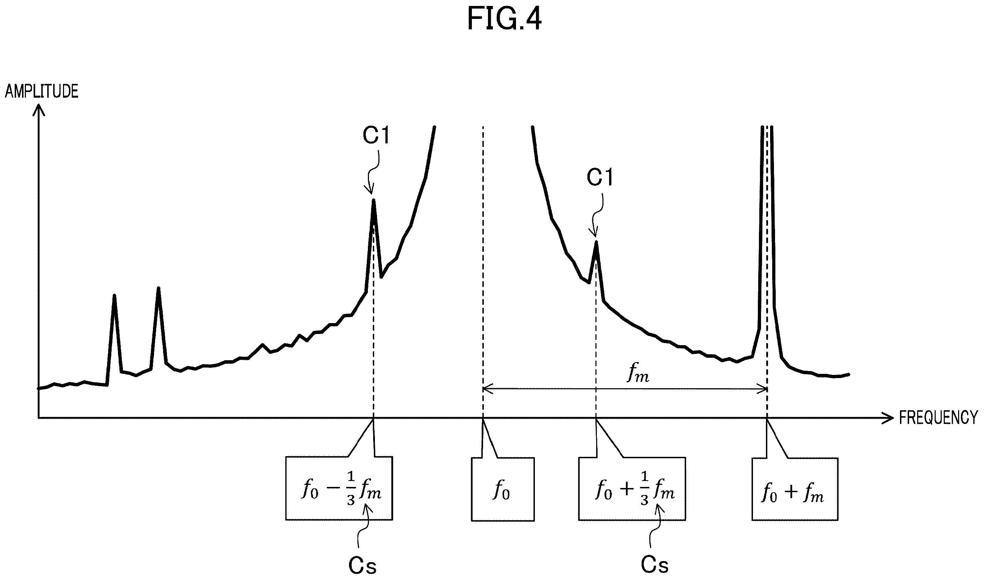

As illustrated in Fig. 4, when the signal is the AC signal, the frequency of the first frequency component (C1) is a frequency (first frequency) obtained by subtracting the frequency of the specific frequency component (Cs) from a fundamental frequency (f0) of the signal, or a frequency (second frequency) obtained by adding the frequency of the specific frequency component (Cs) to the fundamental frequency (f0) of the signal.

In the example of Fig. 4, the frequency of the specific frequency component (Cs) is a frequency "1/3fm" obtained by multiplying the mechanical angular frequency (fm) of the motor (50) by "1/3". The first frequency is "f0 - 1/3fm" and the second frequency is "f0 + 1/3fm". The frequency of the first frequency component (C1) is "f0 - 1/3fm" or "f0 + 1/3fm".

[Specific State]

The specific state is a state in which the first frequency component (C1) of the signal based on the current or voltage of the motor (50) varies (for example, varies in amplitude). The first frequency component (C1) is related to the specific frequency component (Cs) that is less than one time the mechanical angular frequency (fm) of the motor (50).

In other words, the specific state is a state in which the variation in the amplitude of the specific frequency component (Cs) that is less than one time the mechanical angular frequency (fm) of the motor (50) occurs in the torque of the motor (50). When the state of the motor (50) or the device (70) is the specific state, the amplitude of the first frequency component (C1) varies in accordance with the variation in the amplitude occurred in the torque of the motor (50) (variation in the amplitude of the specific frequency component (Cs)).

Specifically, the specific state is a state in which a shaft rotationally driven by the motor (50) or a bearing of the shaft is worn. In other words, the specific state is a state in which the wear amount of the shaft or the bearing exceeds an allowable amount.

When such wear occurs in the shaft or the bearing, the variation in the amplitude of the specific frequency component (Cs) that is less than one time (in particular, 1/3 or 2/3) the mechanical angular frequency (fm) of the motor (50) occurs in the torque of the motor (50). As a result, the first frequency component (C1) of the signal based on the current or voltage of the motor (50) varies (e.g., varies in amplitude).

[Control Process]

In this example, the controller (31) performs a control process. In the control process, the controller (31) controls the motor drive device (20) to control the motor (50). Specifically, the controller (31) inputs a target command value such as a command value of the electrical angular frequency ($\omega$) of the motor (50), detection signals of various sensors provided in the motor drive device (20), and the like. The controller (31) further controls the switching operation of the inverter (23), based on the target command value, the detection signals of various sensors, and the like to control the AC power supplied from the inverter (23) to the motor (50).

For example, the controller (31) includes a processor (computer) and a memory that is electrically connected to the processor and stores a program and information for operating the processor. By the processor executing the program stored in the memory, various functions of the controller (31) are implemented.

[Countermeasure Operation]

When the controller (31) determines in the determination process that the state of the motor (50) or the device (70) is the specific state, the controller (31) performs a countermeasure operation. The countermeasure operation is at least one of an output operation of outputting first information indicating that the state of the motor (50) or the device (70) is the specific state and a change operation of changing an operating condition of the motor (50).

Examples of the output operation include a first output operation, a second output operation, a third output operation, a combination thereof, and the like described below. The first output operation is an operation of outputting the first information to a display device (not illustrated) provided in a remote controller or the like to cause the display device to display the first information. The second output operation is an operation of outputting the first information to the control device (71) that controls the operation of the device (70) to cause the control device (71) to perform an operation for coping with the specific state. The third output operation is an operation of uploading the first information to a data accumulation unit (not illustrated) on the cloud.

Examples of the change operation include a first change operation, a second change operation, a third change operation, a combination thereof, and the like described below. The first change operation is an operation of stopping the motor (50). The second change operation is an operation of accelerating the motor (50). The third change operation is an operation of decelerating the motor (50).

[Effects of Embodiment]

As described above, in the motor drive system (10) of the embodiment, it is possible to determine whether the state of the motor (50) or the device (70) is the specific state. Specifically, it is possible to detect a state in which the shaft rotationally driven by the motor (50) or the bearing of the shaft is worn.

Note that the specific frequency component (Cs) is a frequency component less than one time the mechanical angular frequency (fm) of the motor (50). Specifically, the frequency of the specific frequency component (Cs) is a frequency obtained by multiplying the mechanical angular frequency (fm) by the specific ratio. In addition, the first frequency component (C1) related to the specific frequency component (Cs) is a frequency component that is not generated when the number of rotations or load of the motor (50) is normal and steady. On the other hand, the frequency component of N times (N is a number greater than or equal to 1) the mechanical angular frequency (fm) of the motor (50) is a frequency component that is generated even when the number of rotations or load of the motor (50) is normal and steady, and varies depending on the number of rotations or load of the motor (50).

Therefore, by performing the state determination based on the first frequency component (C1) related to the specific frequency component (Cs), it is possible to easily set a threshold value serving as a criterion for determining the state, as compared with a case where the state determination is performed based on a frequency component of N times (N is a number greater than or equal to 1) the mechanical angular frequency (fm) of the motor (50).

In addition, when first frequency components (C1) of the AC signal are monitored, the first frequency components (C1) are close to a fundamental frequency component having the fundamental frequency (f0) of the AC signal in the center. For example, the first frequency components (C1) appear as sideband waves of the fundamental frequency component. The fundamental frequency component has a frequency width. Therefore, as the first frequency components (C1) are closer to the fundamental frequency component, the first frequency components (C1) are more likely to be affected by the fundamental frequency component, and it is difficult to separate the first frequency components (C1) away from the fundamental frequency component. For example, when the signal based on the current or voltage of the motor (50) is the AC signal, a filter having a steep attenuation gradient is required to separate the first frequency components (C1) away from the fundamental frequency component. However, it is difficult to mount such a filter. In addition, since the first frequency components (C1) appear as the two separated sideband waves of the fundamental frequency component, the amplitude of the first frequency components (C1) of the AC signal is smaller than the amplitude of the first frequency components (C1) of the DC signal.

On the other hand, when first frequency components (C1) of the DC signal are monitored, the fundamental frequency component of the DC signal is a DC amount. When the signal based on the current or voltage of the motor (50) is a DC signal, the fundamental frequency component is a zero hertz component that can be obtained by a simple process such as averaging. Thus, the fundamental frequency component and the first frequency components (C1) can be easily separated by a simple calculation. In addition, since the amplitude of the first frequency components (C1) of the DC signal is larger than the amplitude of the first frequency components (C1) of the AC signal, the SN ratio of the first frequency components (C1) can be improved. Thus, the accuracy of the first frequency components (C1) can be improved. Since the amplitude of the first frequency components (C1) is originally small, it is preferable to use DC to improve the SN ratio.

As described above, by monitoring the first frequency components (C1) of the DC signal, the first frequency components (C1) can be extracted more easily than in the case of monitoring the first frequency components (C1) of the AC signal.

As another method different from the above-described determination process, it is conceivable to determine whether the state of the motor (50) or the device (70) is the specific state, based on an output of a vibration sensor that detects vibration in the motor (50) or the device (70). However, in this method, since noise is easily superimposed on the output of the vibration sensor, it is difficult to accurately determine the state of the motor (50) or the device (70). In addition, it is necessary to separately provide the vibration sensor. As a factor of such noise, an error in the installation position of the vibration sensor or the like may be given.

In the motor drive system (10) of this embodiment, the controller (31) determines whether the state of the motor (50) or the device (70) is the specific state, based on the first frequency component (C1) of the signal based on the current or voltage of the motor (50). The above-described noise is unlikely to be superimposed on the "signal based on the current or voltage of the motor (50)". Therefore, it is possible to more accurately determine the state of the motor (50) or the device (70) than in the above-described method. In addition, an existing current sensor or voltage sensor can be used.

(Specific Examples of Signal)

Next, specific examples of the signal based on the current or voltage of the motor (50) will be described. This signal is roughly classified into a DC signal and an AC signal.

[Specific Examples of DC Signal]

Examples of the DC signal include a "signal correlated with the phase currents (iu, iv, iw) of the motor (50)", a "signal correlated with the phase voltages (Vu, Vv, Vw) of the motor (50)", and a "signal correlated with the electric power of the motor (50)".

Other examples of the DC signal include "currents (iy, iδ) obtained by coordinate conversion of the phase currents (iu, iv, iw) of the motor (50) by a phase (ωi·t) of the phase currents (iu, iv, iw) of the motor (50)", "voltages (Vy, Vδ) obtained by coordinate conversion of the phase voltages (Vu, Vv, Vw) of the motor (50) by a phase (ωv·t) of the phase voltages (Vu, Vv, Vw) of the motor (50)", "currents (iζ, iη) obtained by coordinate conversion of the phase currents (iu, iv, iw) of the motor (50) by the phase (ωv·t) of the phase voltages (Vu, Vv, Vw) of the motor (50)", and "voltages (Vζ, Vη) obtained by coordinate conversion of the phase voltages (Vu, Vv, Vw) of the motor (50) by the phase (ωi·t) of the phase currents (iu, iv, iw) of the motor (50)".

Still other examples of the DC signal include "dq-axis magnetic fluxes (Xd, Xq) obtained by coordinate conversion in accordance with an armature interlinkage magnetic flux by a permanent magnet" and a "magnitude λ0 of an armature interlinkage magnetic flux vector obtained by combining the armature interlinkage magnetic flux of the permanent magnet and the armature reaction".

In the following description, the "phase currents (iu, iv, iw) of the motor (50)" refer to the phase currents (iu, iv, iw) of the motor (50) detected by the phase current detection unit (41). The "phase voltages (Vu, Vv, Vw) of the motor (50)" refer to the phase voltages (Vu, Vv, Vw) of the motor (50) indicated by a voltage command value used inside the controller (31), or the phase voltages (Vu, Vv, Vw) of the motor (50) detected by a phase voltage detection unit (not illustrated) provided in the motor drive device (20). The "electrical angular frequency (ω) of the motor (50)" refers to the electrical angular frequency (ω) of the motor (50) detected by the electrical angular frequency detection unit (42).

[1. Specific Examples of Signal Correlated with Phase Currents of Motor]

Specific examples of the signal correlated with the phase currents (iu, iv, iw) of the motor (50) include a current vector amplitude (Ia), a square value of the current vector amplitude (Ia²), a phase current amplitude (I), a phase current effective value (Irms), and the like.

The current vector amplitude (Ia) and the square value of the current vector amplitude (Ia²) are examples of a value corresponding to the sum of the square values of the three phase currents (iu, iv, iw) of the motor (50). The value corresponding to the sum of the square values of the three phase currents (iu, iv, iw) of the motor (50) is an example of a value proportional to an integer power of the magnitude of the phase currents (iu, iv, iw) of the motor (50).

(1) Current Vector Amplitude

The current vector amplitude (Ia) is derived based on the phase currents (iu, iv, iw) of the motor (50). Alternatively, the current vector amplitude (Ia) may be derived based on an α-phase current (iα) and a β-phase current (iβ) obtained by converting the phase currents (iu, iv, iw) of the motor (50) into a fixed coordinate system. Alternatively, the current vector amplitude (Ia) may be derived based on an M-axis current (iM) and a T-axis current (iT) obtained by coordinate conversion of the phase currents (iu, iv, iw) of the motor (50) by an angle based on the direction of a primary magnetic flux. Alternatively, the current vector amplitude (Ia) may be derived based on a d-axis current (id) and a q-axis current (iq) obtained by coordinate conversion of the phase currents (iu, iv, iw) of the motor (50) by an angle based on the direction of a magnetic pole position. Specifically, the current vector amplitude (Ia) can be expressed by the following equation.

[Math. 1]

$$I_a = \sqrt{i_u^2 + i_v^2 + i_w^2} = \sqrt{i_\alpha^2 + i_\beta^2} = \sqrt{i_M^2 + i_T^2} = \sqrt{i_d^2 + i_q^2}$$

(2) Square Value of Current Vector Amplitude

The square value of the current vector amplitude (Ia²) is derived based on the phase currents (iu, iv, iw) of the motor (50). Alternatively, the square value of the current vector amplitude (Ia2) may be derived based on an α-phase current (iα) and a β-phase current (iβ) obtained by converting the phase currents (iu, iv, iw) of the motor (50) into a fixed coordinate system. Alternatively, the square value of the current vector amplitude (Ia2) may be derived based on an M-axis current (iM) and a T-axis current (iT) obtained by coordinate conversion of the phase currents (iu, iv, iw) of the motor (50) by an angle based on the direction of a primary magnetic flux. Alternatively, the square value of the current vector amplitude (Ia2) may be derived based on a d-axis current (id) and a q-axis current (iq) obtained by coordinate conversion of the phase currents (iu, iv, iw) of the motor (50) by an angle based on the direction of a magnetic pole position. Specifically, the square value of the current vector amplitude (Ia2) can be expressed by the following equation.

[Math. 2]

$$I_a^2 = i_u^2 + i_v^2 + i_w^2 = i_\alpha^2 + i_\beta^2 = i_M^2 + i_T^2 = i_d^2 + i_q^2$$

(3) Phase Current Amplitude

The phase current amplitude (I) is derived based on one phase current (for example, the U-phase current (iu)) among the phase currents (iu, iv, iw) of the motor (50) and a phase (ωi) of the phase current. The phase (ωi) of the phase current is derived, for example, based on the phase currents (iu, iv, iw) of the motor (50). Specifically, the phase current amplitude (I) can be expressed by the following equation.

[Math. 3]

$$I = \frac{i_u}{\cos \omega_i t}$$

(4) Phase Current Effective Value

The phase current effective value (Irms) is derived based on the phase current amplitude (I). Specifically, the phase current effective value (Irms) can be expressed by the following equation.

[Math. 4]

$$I_{rms} = \frac{I}{\sqrt{2}}$$

(5) Others

In the above description, the case where the current vector amplitude (Ia) is derived based on the three phase currents (iu, iv, iw) of the motor (50) has been described as an example. However, the current vector amplitude (Ia) may be derived based on two phase currents of the three phase currents (iu, iv, iw) of the motor (50). Alternatively, the current vector amplitude (Ia) may be derived based on the DC current of the inverter (23) detected by a DC current detection unit (for example, a shunt resistance, not illustrated) provided in the motor drive device (20). The same applies to the square value of the current vector amplitude (Ia2).

[2. Specific Examples of Signal Correlated with Phase Voltages of Motor]

Specific examples of the signal correlated with the phase voltages (Vu, Vv, Vw) of the motor (50) include a voltage vector amplitude (Va), a square value of the voltage vector amplitude (Va2), a phase voltage amplitude (V), a phase voltage effective value (Vrms), and the like.

The voltage vector amplitude (Va) and the square value of the voltage vector amplitude (Va2) are examples of a value corresponding to the sum of the square values of the three phase voltages (Vu, Vv, Vw) of the motor (50). The value corresponding to the sum of the square values of the three phase voltages (Vu, Vv, Vw) of the motor (50) is an example of a value proportional to an integer power of the magnitude of the phase voltages (Vu, Vv, Vw) of the motor (50).

(1) Voltage Vector Amplitude

The voltage vector amplitude (Va) is derived based on the phase voltages (Vu, Vv, Vw) of the motor (50). Alternatively, the voltage vector amplitude (Va) may be derived based on an $\alpha$-phase voltage (V$\alpha$) and a $\beta$-phase voltage (V$\beta$) obtained by converting the phase voltages (Vu, Vv, Vw) of the motor (50) into a fixed coordinate system. Alternatively, the voltage vector amplitude (Va) may be derived based on an M-axis voltage (VM) and a T-axis voltage (VT) obtained by coordinate conversion of the phase voltages (Vu, Vv, Vw) of the motor (50) by an angle based on the direction of a primary magnetic flux. Alternatively, the voltage vector amplitude (Va) may be derived based on a d-axis voltage (Vd) and a q-axis voltage (Vq) obtained by coordinate conversion of the phase voltages (Vu, Vv, Vw) of the motor (50) by an angle based on the direction of a magnetic pole position. Specifically, the voltage vector amplitude (Va) can be expressed by the following equation.

[Math. 5]

$$V_a = \sqrt{v_u^2 + v_v^2 + v_w^2} = \sqrt{v_\alpha^2 + v_\beta^2} = \sqrt{v_M^2 + v_T^2} = \sqrt{v_d^2 + v_q^2}$$

(2) Square Value of Voltage Vector Amplitude

The square value of the voltage vector amplitude (Va$^2$) is derived based on the phase voltages (Vu, Vv, Vw) of the motor (50). Alternatively, the square value of the voltage vector amplitude (Va$^2$) may be derived based on an $\alpha$-phase voltage (V$\alpha$) and a $\beta$-phase voltage (V$\beta$) obtained by converting the phase voltages (Vu, Vv, Vw) of the motor (50) into a fixed coordinate system. Alternatively, the square value of the voltage vector amplitude (Va$^2$) may be derived based on an M-axis voltage (VM) and a T-axis voltage (VT) obtained by coordinate conversion of the phase voltages (Vu, Vv, Vw) of the motor (50) by an angle based on the direction of a primary magnetic flux. Alternatively, the square value of the voltage vector amplitude (Va$^2$) may be derived based on a d-axis voltage (Vd) and a q-axis voltage (Vq) obtained by coordinate conversion of the phase voltages (Vu, Vv, Vw) of the motor (50) by an angle based on the direction of a magnetic pole position. Specifically, the square value of the voltage vector amplitude (Va$^2$) can be expressed by the following equation.

[Math. 6]
$$V_a^2 = v_u^2 + v_v^2 + v_w^2 = v_\alpha^2 + v_\beta^2 = v_M^2 + v_T^2 = v_d^2 + v_q^2$$

(3) Phase Voltage Amplitude

The phase voltage amplitude (V) is derived based on one phase voltage (for example, the U-phase voltage (Vu)) among the phase voltages (Vu, Vv, Vw) of the motor (50) and a phase ($\omega$v) of the phase voltage. The phase ($\omega$v) of the phase voltage is derived, for example, based on the phase voltages (Vu, Vv, Vw) of the motor (50). Specifically, the phase voltage amplitude (V) can be expressed by the following equation.

[Math. 7]

$$V = \frac{v_u}{\cos \omega_v t}$$

(4) Phase Voltage Effective Value

The phase voltage effective value (Vrms) is derived based on the phase voltage amplitude (V). Specifically, the phase voltage effective value (Vrms) can be expressed by the following equation.

[Math. 8]

$$V_{rms} = \frac{V}{\sqrt{2}}$$

(5) Others

In the above description, the case where the voltage vector amplitude (Va) is derived based on the three phase voltages (Vu, Vv, Vw) of the motor (50) has been described as an example. However, the voltage vector amplitude (Va) may be derived based on two phase voltages of the three phase voltages (Vu, Vv, Vw) of the motor (50). The same applies to the square value of the voltage vector amplitude (Va$^2$).

[3. Specific Examples of Signal Correlated with Electric Power of Motor]

Examples of the signal correlated with the electric power of the motor (50) include an instantaneous power (p), an instantaneous imaginary power (q), an apparent power (S), an active power (P), a reactive power (Q), and the like.

(1) Instantaneous Power

The instantaneous power (p) is derived based on the phase currents (iu, iv, iw) of the motor (50) and the phase voltages (Vu, Vv, Vw) of the motor (50). Alternatively, the instantaneous power (p) may be derived based on an α-phase current (iα) and a β-phase current (iβ) obtained by converting the phase currents (iu, iv, iw) of the motor (50) into a fixed coordinate system, and an α-phase voltage (Vα) and a β-phase voltage (Vβ) obtained by converting the phase voltages (Vu, Vv, Vw) of the motor (50) into a fixed coordinate system. Alternatively, the instantaneous power (p) may be derived based on an M-axis current (iM) and a T-axis current (iT) obtained by coordinate conversion of the phase currents (iu, iv, iw) of the motor (50) by an angle based on the direction of a primary magnetic flux, and an M-axis voltage (VM) and a T-axis voltage (VT) obtained by coordinate conversion of the phase voltages (Vu, Vv, Vw) of the motor (50) by an angle based on the direction of a primary magnetic flux. Alternatively, the instantaneous power (p) may be derived based on a d-axis current (id) and a q-axis current (iq) obtained by coordinate conversion of the phase currents (iu, iv, iw) of the motor (50) by an angle based on the direction of a magnetic pole position, and a d-axis voltage (Vd) and a q-axis voltage (Vq) obtained by coordinate conversion of the phase voltages (Vu, Vv, Vw) of the motor (50) by an angle based on the direction of a magnetic pole position. Specifically, the instantaneous power (p) can be expressed by the following equation.

[Math. 9]

$$p = v_u i_u + v_v i_v + v_w i_w = v_\alpha i_\alpha + v_\beta i_\beta = v_M i_M + v_T i_T = v_d i_d + v_q i_q$$

(2) Instantaneous Imaginary Power

The instantaneous imaginary power (q) is derived based on an α-phase current (iα) and a β-phase current (iβ) obtained by converting the phase currents (iu, iv, iw) of the motor (50) into a fixed coordinate system, and an α-phase voltage (Vα) and a β-phase voltage (Vβ) obtained by converting the phase voltages (Vu, Vv, Vw) of the motor (50) into a fixed coordinate system. Alternatively, the instantaneous imaginary power (q) may be derived based on an M-axis current (iM) and a T-axis current (iT) obtained by coordinate conversion of the phase currents (iu, iv, iw) of the motor (50) by an angle based on the direction of a primary magnetic flux, and an M-axis voltage (VM) and a T-axis voltage (VT) obtained by coordinate conversion of the phase voltages (Vu, Vv, Vw) of the motor (50) by an angle based on the direction of a primary magnetic flux. Alternatively, the instantaneous imaginary power (q) may be derived based on a d-axis current (id) and a q-axis current (iq) obtained by coordinate conversion of the phase currents (iu, iv, iw) of the motor (50) by an angle based on the direction of a magnetic pole position, and a d-axis voltage (Vd) and a q-axis voltage (Vq) obtained by coordinate conversion of the phase voltages (Vu, Vv, Vw) of the motor (50) by an angle based on the direction of a magnetic pole position. Specifically, the instantaneous imaginary power (q) can be expressed by the following equation.

[Math. 10]

$$q = v_\alpha i_\beta - v_\beta i_\alpha = v_M i_T - v_T i_M = v_d i_q - v_q i_d$$

(3) Apparent Power

The apparent power (S) is derived based on the phase voltage effective value (Vrms) and the phase current effective value (Irms). Specifically, the apparent power (S) can be expressed by the following equation.

[Math. 11]

$$S = 3V_{rms}I_{rms}$$

(4) Active Power

The active power (P) is derived based on the phase voltage effective value (Vrms), the phase current effective value (Irms), and a phase difference ($\varphi$1) between a phase voltage and a phase current. The phase difference ($\varphi$1) between a phase voltage and a phase current is a phase difference between one phase voltage (for example, the U-phase voltage (Vu)) and one phase current (for example, the U-phase current (iu)), and is derived based on the phase ($\omega$i) of the phase current and the phase ($\omega$v) of the phase voltage. Specifically, the active power (P) can be expressed by the following equation.

[Math. 12]

$$P = 3V_{rms}I_{rms}\cos\varphi_1$$

(5) Reactive Power

The reactive power (Q) is derived based on the phase voltage effective value (Vrms), the phase current effective value (Irms), and a phase difference ($\varphi$1) between a phase voltage and a phase current. The phase difference ($\varphi$1) between a phase voltage and a phase current is, for example, a phase difference between the U-phase voltage (Vu) and the U-phase current (iu), and is derived based on the phase ($\omega$i) of the phase current and the phase ($\omega$v) of the phase voltage. Specifically, the reactive power (Q) can be expressed by the following equation.

[Math. 13]

$$Q = -3V_{rms}I_{rms}\sin\varphi_1$$

[4. Currents Obtained by Coordinate Conversion of Phase Currents by Phase of Phase Currents]

The currents (iγ, iδ) obtained by coordinate conversion of the phase currents (iu, iv, iw) of the motor (50) by the phase ($\omega$i ·t) of the phase currents (iu, iv, iw) of the motor (50) can be expressed by the following equation.

[Math. 14]

$$\begin{bmatrix} i_\gamma \\ i_\delta \end{bmatrix} = k \begin{bmatrix} \cos\omega_i t & \cos\left(\omega_i t - \frac{2}{3}\pi\right) & \cos\left(\omega_i t - \frac{4}{3}\pi\right) \\ -\sin\omega_i t & -\sin\left(\omega_i t - \frac{2}{3}\pi\right) & -\sin\left(\omega_i t - \frac{4}{3}\pi\right) \end{bmatrix} \begin{bmatrix} i_u \\ i_v \\ i_w \end{bmatrix}$$

[5. Voltages Obtained by Coordinate Conversion of Phase Voltages by Phase of Phase Voltages]

The voltages (Vγ, Vδ) obtained by coordinate conversion of the phase voltages (Vu, Vv, Vw) of the motor (50) by the phase ($\omega$v ·t) of the phase voltages (Vu, Vv, Vw) of the motor (50) can be expressed by the following equation.

[Math. 15]

$$\begin{bmatrix} v_\gamma \\ v_\delta \end{bmatrix} = k \begin{bmatrix} \cos \omega_v t & \cos\left(\omega_v t - \dfrac{2}{3}\pi\right) & \cos\left(\omega_v t - \dfrac{4}{3}\pi\right) \\ -\sin \omega_v t & -\sin\left(\omega_v t - \dfrac{2}{3}\pi\right) & -\sin\left(\omega_v t - \dfrac{4}{3}\pi\right) \end{bmatrix} \begin{bmatrix} v_u \\ v_v \\ v_w \end{bmatrix}$$

[6. Currents Obtained by Coordinate Conversion of Phase Currents by Phase of Phase Voltages]

The currents (iζ, iη) obtained by coordinate conversion of the phase currents (iu, iv, iw) of the motor (50) by the phase (ωv ·t) of the phase voltages (Vu, Vv, Vw) of the motor (50) can be expressed by the following equation.

[Math. 16]

$$\begin{bmatrix} i_\zeta \\ i_\eta \end{bmatrix} = k \begin{bmatrix} \cos \omega_v t & \cos\left(\omega_v t - \dfrac{2}{3}\pi\right) & \cos\left(\omega_v t - \dfrac{4}{3}\pi\right) \\ -\sin \omega_v t & -\sin\left(\omega_v t - \dfrac{2}{3}\pi\right) & -\sin\left(\omega_v t - \dfrac{4}{3}\pi\right) \end{bmatrix} \begin{bmatrix} i_u \\ i_v \\ i_w \end{bmatrix}$$

[7. Voltages Obtained by Coordinate Conversion of Phase Voltages by Phase of Phase Currents]

The voltages (Vζ, Vη) obtained by coordinate conversion of the phase voltages (Vu, Vv, Vw) of the motor (50) by the phase (ωi ·t) of the phase currents (iu, iv, iw) of the motor (50) can be expressed by the following equation.

[Math. 17]

$$\begin{bmatrix} v_\zeta \\ v_\eta \end{bmatrix} = k \begin{bmatrix} \cos \omega_i t & \cos\left(\omega_i t - \dfrac{2}{3}\pi\right) & \cos\left(\omega_i t - \dfrac{4}{3}\pi\right) \\ -\sin \omega_i t & -\sin\left(\omega_i t - \dfrac{2}{3}\pi\right) & -\sin\left(\omega_i t - \dfrac{4}{3}\pi\right) \end{bmatrix} \begin{bmatrix} v_u \\ v_v \\ v_w \end{bmatrix}$$

[8. Dq-axis Magnetic Fluxes and Magnitude of Armature Interlinkage Magnetic Flux Vector]

The dq-axis magnetic fluxes (λd, λq) obtained by coordinate conversion in accordance with an armature interlinkage magnetic flux by a permanent magnet and the magnitude λ0 of an armature interlinkage magnetic flux vector obtained by combining the armature interlinkage magnetic flux of the permanent magnet and the armature reaction can be expressed by the following equations. In the following equations, "Ld" is a d-axis inductance and "Lq" is a q-axis inductance.

[Math. 18]

$$\begin{bmatrix} \lambda_d \\ \lambda_q \end{bmatrix} = \begin{bmatrix} L_d & 0 \\ 0 & L_q \end{bmatrix} \begin{bmatrix} i_d \\ i_q \end{bmatrix} + \begin{bmatrix} \Lambda_a \\ 0 \end{bmatrix}$$

$$\lambda_0 = \sqrt{\lambda_d^2 + \lambda_q^2}$$

[9. Other Examples of DC Signal]

The DC signal may also be a DC signal obtained by performing three phase to two phase conversion on a phase current, a phase voltage, a line current, or a line voltage of the motor (50) and further performing rotational coordinate conversion thereon. For example, the DC signal may be a d-axis current and a q-axis current obtained by performing rotational coordinate conversion on an $\alpha$-axis current and a $\beta$-axis current obtained by performing three phase to two phase conversion on the phase current of the motor (50) at an angle based on the direction of a magnetic pole of the rotor of the motor (50). Alternatively, the DC signal may be an M-axis current and a T-axis current obtained by performing rotational coordinate conversion on an $\alpha$-axis current and a $\beta$-axis current at an angle based on the direction of a primary magnetic flux of the rotor of the motor (50).

The DC signal may be electric power input to the converter (21) of the motor drive device (20), electric power output from the converter (21), electric power output from the DC unit (22), a current flowing between the converter (21) and the DC unit (22), a current flowing between the DC unit (22) and the inverter (23), or the like.

[Specific Examples of AC Signal]

Examples of the AC signal include the "phase currents (iu, iv, iw) of the motor (50)", the "phase voltages (Vu, Vv, Vw) of the motor (50)", and "interlinkage magnetic fluxes ($\Psi$fu, $\Psi$fv, $\Psi$fw) of the respective phases".

The interlinkage magnetic fluxes ($\Psi$fu, $\Psi$fv, $\Psi$fw) of the respective phases can be expressed by the following expressions.

[Math. 19]

$$\psi_{fu} = \frac{\sqrt{2}}{3}\lambda_0 \cos\theta$$

$$\psi_{fv} = \frac{\sqrt{2}}{3}\lambda_0 \cos\left(\theta - \frac{2}{3}\pi\right)$$

$$\psi_{fw} = \frac{\sqrt{2}}{3}\lambda_0 \cos\left(\theta + \frac{2}{3}\pi\right)$$

Another example of the AC signal includes a current, a voltage, and an interlinkage magnetic flux of fixed coordinates obtained by three phase to two phase conversion of the above AC signal.

Alternatively, the AC signal may be a line current, a line voltage, or the like of the motor (50). Alternatively, the AC signal may be a two phase AC current (for example, an $\alpha$-axis current and a $\beta$-axis current) or a two phase AC voltage obtained by three phase to two phase conversion of a phase current, a phase voltage, a line current, or a line voltage. The AC current may be a current flowing between a commercial power source system (specifically, the AC power source (60)) and the converter (21) of the motor drive device (20).

(Specific Examples of Determination Process)

Next, the determination process will be described with reference to four specific examples (first to fourth determination processes). Hereinafter, a case where the determination process is performed based on the amplitude of the first frequency component (C1) will be described as an example. In the following description, the "first frequency component (C1)" refers to the "amplitude of the first frequency component (C1)".

[First Determination Process]

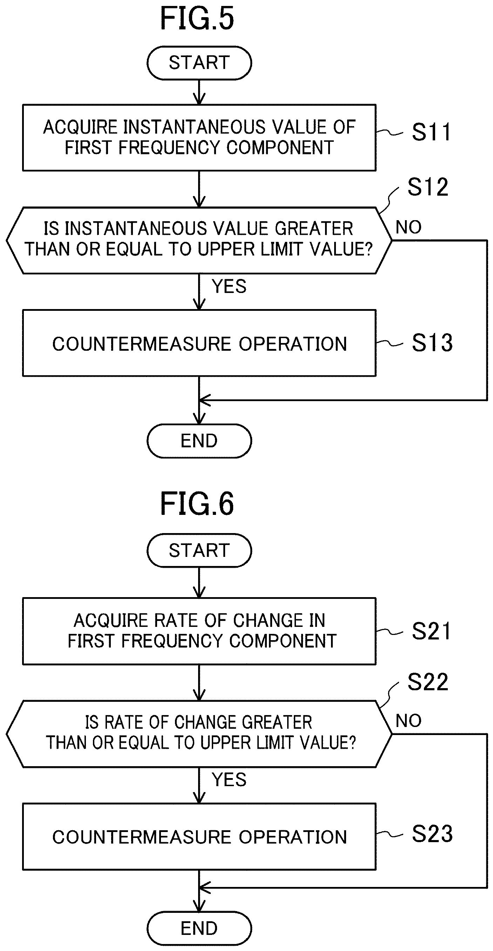

Next, the first determination process will be described with reference to Fig. 5. In the first determination process, the controller (31) determines whether the state of the motor (50) or the device (70) is the specific state, based on an instantaneous value of the first frequency component (c1). Specifically, the controller (31) performs the following process (step (S11) to step (S13)) for each predetermined detection cycle.

<Step (S 11)>

The controller (31) acquires an instantaneous value of the first frequency component (C1).

<Step (S12)>

Subsequently, the controller (31) determines whether the instantaneous value of the first frequency component (C1) acquired in the step (S11) is greater than or equal to a predetermined upper limit value. When the instantaneous value of the first frequency component (C1) is greater than or equal to the upper limit value, step (S13) is performed. On the other hand, if not, the first determination process ends.

<Step (S13)>

When the instantaneous value of the first frequency component (C1) is greater than or equal to the upper limit value in step (S12), the controller (31) determines that the state of the motor (50) or the device (70) is the specific state. Then, the controller (31) performs the countermeasure operation.

[Second Determination Process]

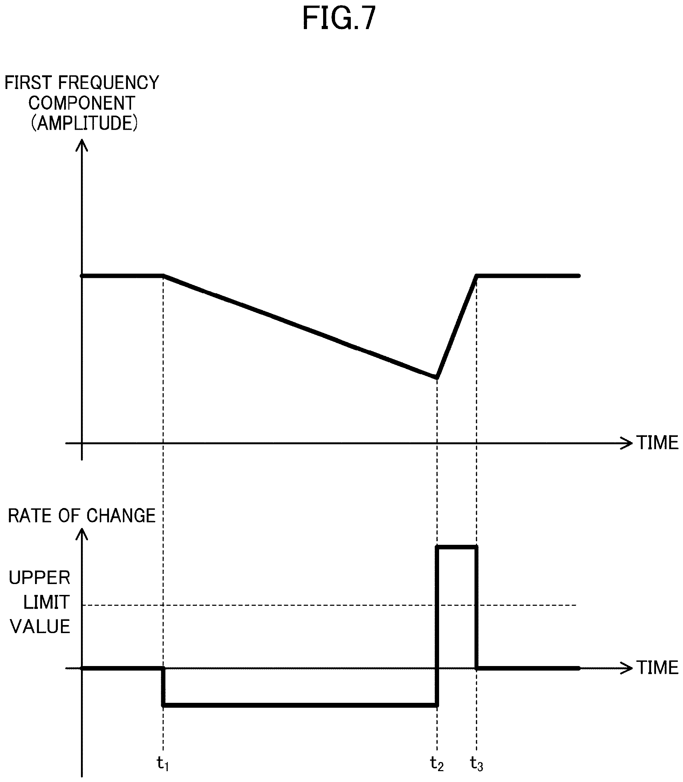

The second determination process will be described with reference to Figs. 6 and 7. In the second determination process, the controller (31) determines whether the state of the motor (50) or the device (70) is the specific state, based on a rate of change in the first frequency component (C1). Specifically, the controller (31) repeatedly performs the following process (step (S21) to step (S23)) for each predetermined detection cycle.

<Step (S21)>

The controller (31) acquires a rate of change in the first frequency component (c1). For example, the controller (31) derives the rate of change in the first frequency component (C1) by differentiating the instantaneous value of the first frequency component (C1) with respect to time. In the example of Fig. 7, the rate of change in the first frequency component (C1) changes at each of times (t1, t2, t3).

<Step (S22)>

The controller (31) determines whether the rate of change in the first frequency component (C1) acquired in step (S21) is greater than or equal to a predetermined upper limit value. When the rate of change in the first frequency component (C1) is greater than or equal to the upper limit value, step (S23) is performed. On the other hand, if not, the second determination process ends. In the example of Fig. 7, the rate of change in the first frequency component (C1) is greater than or equal to the upper limit value at the time (t2).

<Step (S23)>

When the rate of change in the first frequency component (C1) is greater than or equal to the upper limit value in step (S22), the controller (31) determines that the state of the motor (50) or the device (70) is the specific state. Then, the controller (31) performs the countermeasure operation.

[Third Determination Process]

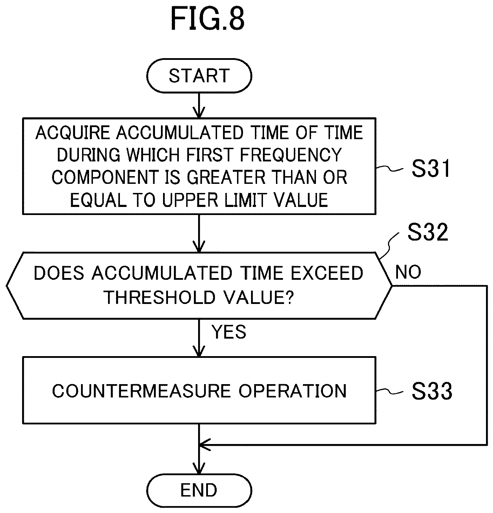

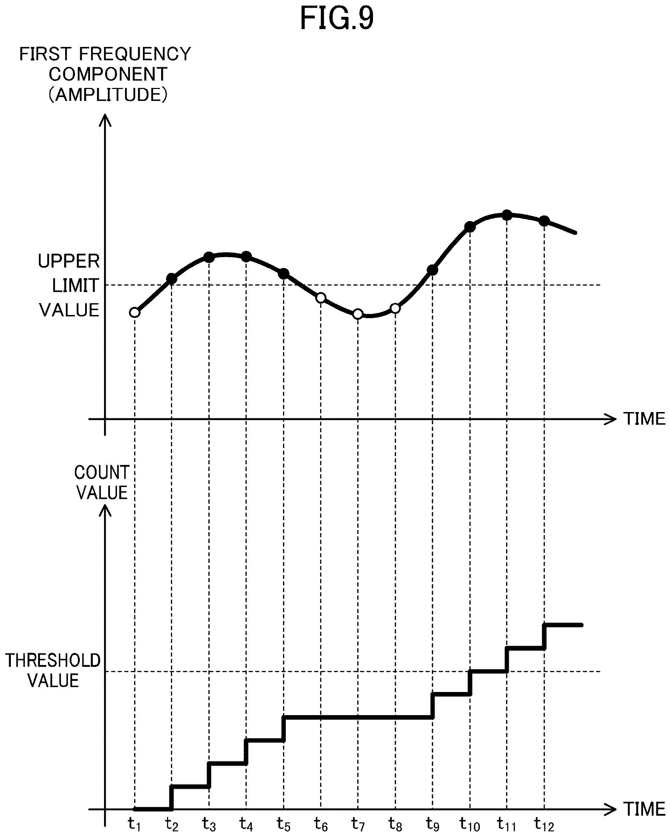

The third determination process will be described with reference to Figs. 8 and 9. In the third determination process, the controller (31) determines whether the state of the motor (50) or the device (70) is the specific state, based on an accumulated time obtained by accumulating times during which the first frequency component (C1) is greater than or equal to an upper limit value. Specifically, the controller (31) repeatedly performs the following process (step (S31) to step (S33)) for each predetermined detection cycle.

<Step (S31)>

The controller (31) acquires an accumulated value of time (accumulated time) during which the first frequency component (C1) is greater than or equal to an upper limit value.
For example, the controller (31) acquires an instantaneous value of the first frequency component (C1), which is a typical value in the detection cycle, and determines whether the instantaneous value of the first frequency component (C1) is greater than or equal to the upper limit value. Then, the controller (31) increments the count value when the instantaneous value of the first frequency component (C1) is greater than or equal to the upper limit value, and does not increment the count value when the instantaneous value of the first frequency component (C1) is not greater than or equal to the upper limit value. The count value corresponds to the accumulated value of time (accumulated time) during which the first frequency component (C1) is greater than or equal to the upper limit value. For example, a value obtained by multiplying the count value by a time corresponding to the detection cycle is the accumulated time.

In the example of Fig. 9, the third determination process is performed at each of times (t1 to t12), and the count value is incremented at the times (t2 to t5, t9 to t12) among the times (t1 to t12).

<Step (S32)>

Subsequently, the controller (31) determines whether the accumulated time (the count value in this example) acquired in step (S31) exceeds a predetermined threshold value. When the accumulated time exceeds the threshold value, step (S33) is performed. On the other hand, when the accumulated time does not exceed the threshold value, the third determination process ends. In the example of Fig. 9, the controller (31) determines that the count value exceeds the threshold value at the time (t11).

<Step (S33)>

When the accumulated time exceeds the threshold value in step (S32), the controller (31) determines that the state of the motor (50) or the device (70) is the specific state. Then, the controller (31) performs the countermeasure operation.

[Fourth Determination Process]

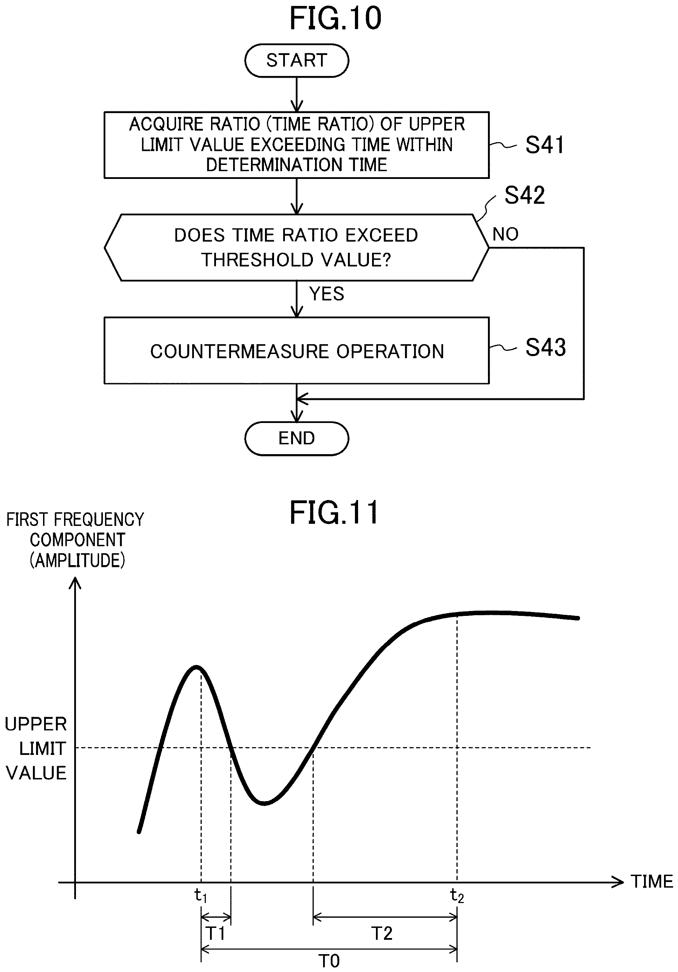

The fourth determination process will be described with reference to Figs. 10 and 11. In the fourth determination process, the controller (31) determines whether the state of the motor (50) or the device (70) is the specific state, based on a ratio of time (time ratio) during which the first frequency component (C1) is greater than or equal to a predetermined upper limit value within a predetermined determination time. Specifically, the controller (31) repeatedly performs the following process (step (S41) to step (S43)) for each predetermined detection cycle.

<Step (S41)>

The controller (31) acquires a ratio of time (time ratio) during which the first frequency component (C1) is greater than or equal to an upper limit value within a determination time.

For example, the controller (31) stores the first frequency component (C1) within a predetermined time period (at least a period corresponding to the determination time) ending at the current time. Then, based on the stored first frequency component (C1), the controller (31) derives a time (upper limit value exceeding time) during which the first frequency component (C1) is greater than or equal to the upper limit value within the determination period that ends at the current time and has a duration corresponding to the determination time, and derives the time ratio by dividing the upper limit value exceeding time by the determination time. In the example of Fig. 11, a time (t2) is the current time, the period from a time (t1) to the time (t2) is the determination period, a time (T1) and a time (T2) are the upper limit value exceeding times, and the value obtained by dividing the sum of the time (T1) and the time (T2) by a determination time (T0) is the time ratio.

<Step (S42)>

Subsequently, the controller (31) determines whether the time ratio (the ratio of time during which the first frequency component is greater than or equal to the upper limit value within the determination time) acquired in step (S41) exceeds a predetermined threshold value. When the time ratio exceeds the threshold value, step (S43) is performed. On the other hand, if not, the fourth determination process ends.

<Step (S43)>

When the time ratio exceeds the threshold value in step (S42), the controller (31) determines that the state of the motor (50) or the device (70) is the specific state. Then, the controller (31) performs the countermeasure operation.

In the above description of the determination process, the case where the first frequency component (C1) is compared with the upper limit value has been described as an example. However, the present disclosure is not limited to this. For example, the first frequency component (C1) may be compared with a predetermined lower limit value. That is, "greater than or equal to the upper limit value" in the above description may be read as "less than or equal to the lower limit value". Alternatively, the first frequency component (C1) may be compared with a predetermined allowable range. That is, "greater than or equal to the upper limit value" in the above description may be read as "out of the allowable range".

(Refrigeration System)

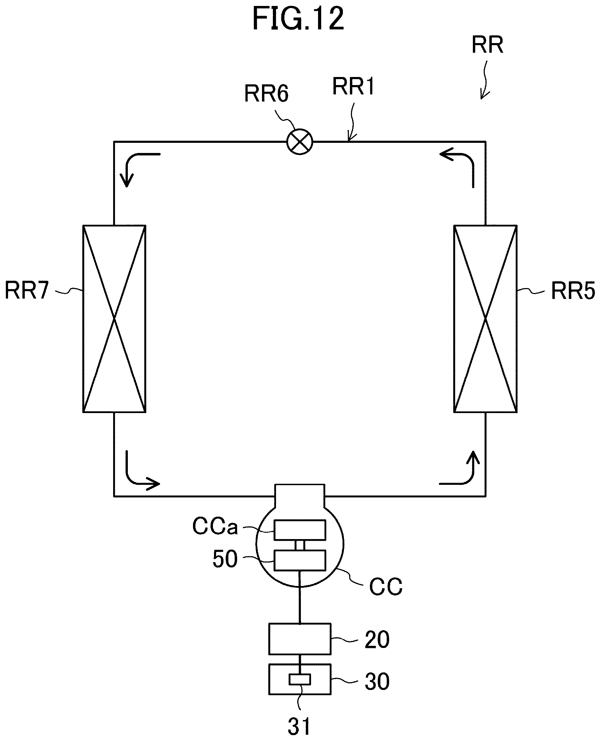

Fig. 12 illustrates a configuration of a refrigeration system (RR). The refrigeration system (RR) includes a refrigerant circuit (RR1) filled with a refrigerant, the motor drive device (20), and the state determination device (30).

The refrigerant circuit (RR1) includes a compressor (CC), a radiator (RR5), a decompression mechanism (RR6), and an evaporator (RR7). In this example, the decompression mechanism (RR6) is an expansion valve. The refrigerant circuit (RR1) performs a vapor compression refrigeration cycle.

The compressor (CC) includes a compression mechanism (CCa) and the motor (50). The compression mechanism (CCa) is coupled to the motor (50) by a shaft. The motor (50) rotationally drives the compression mechanism (CCa) by rotationally driving the shaft. The motor drive device (20) drives the motor (50). The state determination device (30) determines the state of the motor (50) or the compressor (CC) on which the motor (50) is mounted.

In the refrigeration cycle, the refrigerant discharged from the compressor (CC) radiates heat in the radiator (RR5). The refrigerant flowing out of the radiator (RR5) is decompressed in the decompression mechanism (RR6) and evaporated in the evaporator (RR7). Then, the refrigerant flowing out of the evaporator (RR7) is sucked into the compressor (CC).

In this example, the refrigeration system (RR) is an air conditioner. The air conditioner may be a cooling dedicated machine or a heating dedicated machine. Alternatively, the air conditioner may be an air conditioner that switches between cooling and heating. In this case, the air conditioner includes a switching mechanism (for example, a four-way switching valve) that switches the circulation direction of the refrigerant. Alternatively, the refrigeration system (RR) may be a water heater, a chiller unit, a cooling apparatus for cooling air in a space, or the like. The cooling apparatus cools air inside a refrigerator, a freezer, a container, or the like.

(Fan System)

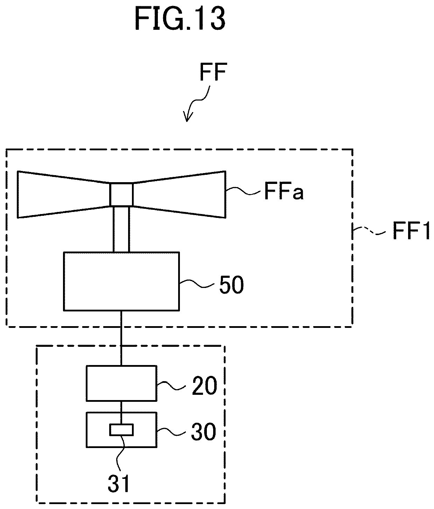

Fig. 13 illustrates a configuration of a fan system (FF). The fan system (FF) includes a fan (FF1), the motor drive device (20), and the state determination device (30).

The fan (FF1) includes a rotor (FFa) having blades and the motor (50). The rotor (FFa) is coupled to the motor (50) by a shaft. The motor (50) rotationally drives the rotor (FFa) by rotationally driving the shaft. The motor drive device (20) drives the motor (50). The state determination device (30) determines the state of the motor (50) or the fan (FF1) on which the motor (50) is mounted.

(Specific Examples of Bearing)

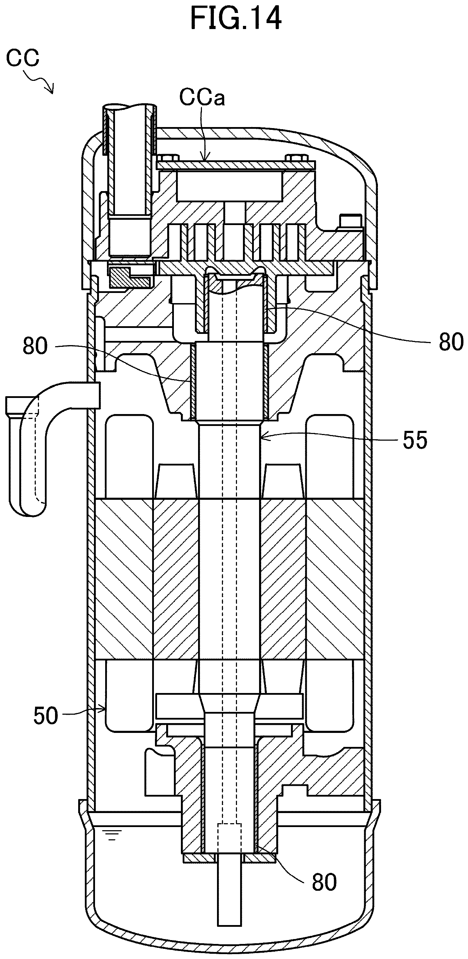

As illustrated in Fig. 14, each of bearings (80) supporting a shaft (55) rotationally driven by the motor (50) may be a sliding bearing. In other words, the motor (50) may rotationally drive the shaft (55) supported by the sliding bearing. The sliding bearing is an example of the bearing (80).

When the bearing (80) supporting the shaft (55) rotationally driven by the motor (50) is the "sliding bearing", wear of the shaft (55) or the bearing (80) causes the variation in the amplitude of the specific frequency component (Cs) that is less than one time (specifically, 1/3 or 2/3) the mechanical angular frequency (fm) of the motor (50) to occur in the torque of the motor (50). As a result, as illustrated in Fig. 3 or 4, the first frequency component (C1) of the signal based on the current or voltage of the motor (50) varies (for example, varies in amplitude).

This is presumably because, when the amount of wear of the shaft (55) or the bearing (80) exceeds an allowable amount, the bearing (80) is loosened or rattled to change the orbit of rotation of the shaft (55) supported by the bearing (80) (specifically, the sliding bearing).

(Other Embodiments)

In the above description, the determination process may be performed based on each of a plurality of (two in the examples of Figs. 3 and 4) first frequency components (C1), or may be performed based on any of the plurality of first frequency components (C1). In addition, the determination process may be performed based on only one of the DC signal and the AC signal, or may be performed based on each of the DC signal and the AC signal.

In addition, in the above description, the case where the determination process is performed based on the amplitude of the first frequency component (C1) has been described as an example. However, the determination process may be performed based on the phase of the first frequency component (C1), or the determination process may be performed based on the spectral width of the first frequency component (C1).

In addition, the controller (31) may be configured to perform the determination process using an algorithm (an algorithm for determining a state based on a change in a signal) constructed by a neural network or machine learning.

In addition, the controller (31) may be implemented by one processor or may be implemented by a plurality of processors. In addition, the controller (31) may be implemented by a plurality of arithmetic processing devices (computers) that communicate with each other via a communication network.

In addition, in the above description, the case where the DC unit (22) includes a capacitor has been described as an example. However, the present disclosure is not limited to this. For example, the DC unit (22) may be an LC circuit including a capacitor and a reactor. With such a configuration, it is possible to suppress a noise current accompanying a switching operation by the switching elements of the inverter (23) from flowing into the AC power source (60). The electrostatic capacitance value of the capacitor may be set to an electrostatic capacitance value at which the output of the converter (21) can hardly be smoothed but a ripple generated by the switching operation of the inverter (23) can be smoothed. Specifically, the capacitor may be a small-capacitance capacitor having an electrostatic capacitance value that is about 1/100 times the electrostatic capacitance value of a smoothing capacitor (e.g., an electrolytic capacitor) used for smoothing the output of the converter (21) in a general power conversion apparatus.

While the embodiments and modifications have been described, it will be understood that various changes in form and detail may be made without departing from the spirit and scope of the appended claims. The above embodiments and modifications can be combined or substituted as appropriate unless the function of the subject matter of the present disclosure is degraded.

Industrial Applicability

As described above, the present disclosure is useful as a state determination technique.

Reference Signs List

10    motor drive system
20    motor drive device
30    state determination device
31    controller
41    phase current detection unit
42    electrical angular frequency detection unit
50    motor
60    AC power source
C1    first frequency component
Cs    specific frequency component
RR    refrigeration system
FF    fan system

**Claims**

1.  A state determination device configured to determine a state of a motor (50) driven by a motor drive device (20) or a device (70) on which the motor (50) is mounted, the state determination device comprising:

    a controller (31) configured to determine whether the state of the motor (50) or the device (70) is a specific state, based on a first frequency component (C1) of a signal based on a current or voltage of the motor (50), wherein
    when the signal is a DC signal, a frequency of the first frequency component (C1) is a frequency of a specific frequency component (Cs),
    when the signal is an AC signal, the frequency of the first frequency component (C1) is a frequency obtained by subtracting the frequency of the specific frequency component (Cs) from a fundamental frequency (f0) of the signal or a frequency obtained by adding the frequency of the specific frequency component (Cs) to the fundamental frequency (f0) of the signal, and
    the specific frequency component (Cs) is a frequency component less than one time a mechanical angular frequency (fm) of the motor (50).

2. The state determination device according to claim 1, wherein
the motor (50) is configured to rotationally drive a shaft (55) supported by a sliding bearing.

3. The state determination device according to claim 1 or 2, wherein
the DC signal indicates a square root of a sum of square values of phase currents (iu, iv, iw) of the motor (50).

4. The state determination device according to any one of claims 1 to 3, wherein
the frequency of the specific frequency component (Cs) is a frequency obtained by multiplying the mechanical angular frequency (fm) of the motor (50) by a specific ratio.

5. The state determination device according to claim 4, wherein
the specific ratio is a fractional ratio represented by a reciprocal of a natural number.

6. The state determination device according to any one of claims 1 to 5, wherein
the specific state is a state in which a shaft rotationally driven by the motor (50) or a bearing of the shaft is worn.

7. The state determination device according to claim 4, wherein

   the specific state is a state in which a shaft rotationally driven by the motor (50) or a bearing of the shaft is worn, and
   the specific ratio is 1/3 or 2/3.

8. A motor drive system comprising:

   a motor drive device (20) configured to drive a motor (50) mounted on a device (70); and
   a state determination device (30) configured to determine a state of the motor (50) or the device (70), wherein
   the state determination device (30) is the state determination device according to any one of claims 1 to 7.

9. A refrigeration system comprising:

   a refrigerant circuit (RR1) including a compressor (CC);
   a motor drive device (20) configured to drive a motor (50) mounted on the compressor (CC); and
   a state determination device (30) configured to determine a state of the motor (50) or the compressor (CC), wherein
   the state determination device (30) is the state determination device according to any one of claims 1 to 7.

10. A fan system comprising:

    a fan (FF);
    a motor drive device (20) configured to drive a motor (50) mounted on the fan (FF); and
    a state determination device (30) configured to determine a state of the motor (50) or the fan (FF), wherein
    the state determination device (30) is the state determination device according to any one of claims 1 to 7.

11. A state determination method for determining a state of a motor (50) driven by a motor drive device (20) or a device (70) on which the motor (50) is mounted, the state determination method comprising:

    acquiring a first frequency component (C1) of a signal based on a current or voltage of the motor (50); and
    determining whether the state of the motor (50) or the device (70) is a specific state, based on the first frequency component (C1), wherein
    when the signal is a DC signal, a frequency of the first frequency component (C1) is a frequency of a specific frequency component (Cs),
    when the signal is an AC signal, the frequency of the first frequency component (C1) is a frequency obtained by subtracting the frequency of the specific frequency component (Cs) from a fundamental frequency (f0) of the signal or a frequency obtained by adding the frequency of the specific frequency component (Cs) to the fundamental frequency (f0) of the signal, and
    the specific frequency component (Cs) is a frequency component less than one time a mechanical angular frequency (fm) of the motor (50).

# FIG.1

EP 4 489 295 A1

FIG.2

$$\sqrt{(i_u^2 + i_v^2 + i_w^2)}$$

$i_w$

$i_v$

$i_u$

0

# FIG.3

EP 4 489 295 A1

# FIG.4

AMPLITUDE

C1

C1

$f_m$

FREQUENCY

$f_0 - \frac{1}{3}f_m$

$f_0$

$f_0 + \frac{1}{3}f_m$

$f_0 + f_m$

Cs

Cs

EP 4 489 295 A1

## FIG.5

START

ACQUIRE INSTANTANEOUS VALUE OF
FIRST FREQUENCY COMPONENT — S11

IS INSTANTANEOUS VALUE GREATER
THAN OR EQUAL TO UPPER LIMIT VALUE? — S12    NO

YES

COUNTERMEASURE OPERATION — S13

END

## FIG.6

START

ACQUIRE RATE OF CHANGE IN
FIRST FREQUENCY COMPONENT — S21

IS RATE OF CHANGE GREATER
THAN OR EQUAL TO UPPER LIMIT VALUE? — S22    NO

YES

COUNTERMEASURE OPERATION — S23

END

# FIG.7

FIRST FREQUENCY
COMPONENT
(AMPLITUDE)

TIME

RATE OF CHANGE

UPPER
LIMIT
VALUE

TIME

$t_1$          $t_2$  $t_3$

# FIG.8

```
        START
          │
          ▼
┌──────────────────────────┐
│ ACQUIRE ACCUMULATED TIME OF TIME │
│ DURING WHICH FIRST FREQUENCY     │   S31
│ COMPONENT IS GREATER THAN OR     │
│ EQUAL TO UPPER LIMIT VALUE       │
└──────────────────────────┘
          │
          ▼                           S32
     ╱────────────────────────╲
    ╱ DOES ACCUMULATED TIME EXCEED ╲  NO
    ╲     THRESHOLD VALUE?         ╱ ──────┐
     ╲────────────────────────╱            │
          │ YES                            │
          ▼                                │
┌──────────────────────────┐               │
│  COUNTERMEASURE OPERATION │   S33         │
└──────────────────────────┘               │
          │                                 │
          ▼◄────────────────────────────────┘
        END
```

# FIG.9

FIRST FREQUENCY
COMPONENT
(AMPLITUDE)

UPPER
LIMIT
VALUE

TIME

COUNT
VALUE

THRESHOLD
VALUE

TIME

$t_1$  $t_2$  $t_3$  $t_4$  $t_5$  $t_6$  $t_7$  $t_8$  $t_9$  $t_{10}$  $t_{11}$  $t_{12}$

# FIG.10

```
                    ┌─────────┐
                    │  START  │
                    └─────────┘
                         │
                         ▼
    ┌─────────────────────────────────────────┐
    │ ACQUIRE RATIO (TIME RATIO) OF UPPER      │
    │ LIMIT VALUE EXCEEDING TIME WITHIN        │~ S41
    │ DETERMINATION TIME                        │
    └─────────────────────────────────────────┘
                         │
                         ▼              S42
              ╱──────────────────────╲
             ╱   DOES TIME RATIO       ╲   NO
             ╲   EXCEED                 ╱──────────┐
              ╲  THRESHOLD VALUE?      ╱           │
               ╲──────────────────────╱            │
                         │ YES                      │
                         ▼                          │
    ┌─────────────────────────────────────────┐    │
    │      COUNTERMEASURE OPERATION            │~ S43│
    └─────────────────────────────────────────┘    │
                         │                          │
                         ▼◄─────────────────────────┘
                    ┌─────────┐
                    │   END   │
                    └─────────┘
```

# FIG.11

FIRST FREQUENCY
COMPONENT
(AMPLITUDE)

UPPER
LIMIT
VALUE

TIME

$t_1$   $t_2$

T1   T2

T0

# FIG.12

RR

RR6   RR1

RR7

RR5

CCa

50

CC

20

30

31

# FIG.13

FF

FFa

FF1

50

20

30

31

# FIG.14

## INTERNATIONAL SEARCH REPORT

International application No.

**PCT/JP2023/010040**

**A. CLASSIFICATION OF SUBJECT MATTER**

*H02P 29/024*(2016.01)i
FI:  H02P29/024

According to International Patent Classification (IPC) or to both national classification and IPC

**B. FIELDS SEARCHED**

Minimum documentation searched (classification system followed by classification symbols)

H02P29/024

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2019/082277 A1 (MITSUBISHI ELECTRIC CORP.) 02 May 2019 (2019-05-02) paragraphs [0012]-[0059], fig. 1-15 | 1-11 |

☐ Further documents are listed in the continuation of Box C.        ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **25 May 2023** | **06 June 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**
Information on patent family members

International application No.

**PCT/JP2023/010040**

| Patent document cited in search report | Publication date (day/month/year) | Patent family member(s) | Publication date (day/month/year) |
|---|---|---|---|
| WO 2019/082277 A1 | 02 May 2019 | US 2020/0217895 A1 paragraphs [0026]-[0073], fig. 1-15 | |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017221023 A